# EUROPEAN PATENT APPLICATION

(11) **EP 4 761 553 A1**
(43) Date of publication of application: **17.06.2026**
(21) Application number: 24218830.8
(22) Date of filing: 10.12.2024
(51) Int. Cl.: H10N 69/00, H10D 1/00, H10D 1/68, H10N 60/01

(54) **A CAPACITOR INTEGRATED IN A SUPERCONDUCTING DIGITAL CIRCUIT AND METHOD OF PRODUCING THEREOF**

(71) Applicant: Imec VZW, 3001 Leuven (BE); IMEC USA NANOELECTRONICS DESIGN CENTER, Inc., Kissimmee, Florida 34744-4430 (US)
(72) Inventor: Pokhrel, Ms. Ankit, 3001 Leuven (BE); Tokei, Mr. Zsolt, 3001 Leuven (BE); Herr, Ms. Anna, 3001 Leuven (BE); Popovici, Ms. Mihaela Ioana, 3001 Leuven (BE); Huet, Mr. Benjamin, 3001 Leuven (BE)
(74) Representative: Patent Department IMEC

(57) **Abstract**

The invention is related to a micro-electronic component comprising superconducting digital logic circuitry, including at least one capacitor that comprises a bottom and top electrode (6',8') formed of superconducting NbTiN, and a dielectric interlayer (7') formed of orthorhombic HZO. A method for producing the capacitor includes method steps for producing of NbTiN electrodes defined by atomic concentrations of its constituent elements which enable superconductivity as well as the formation of HZO in the orthorhombic phase that remains stable throughout the sequence of method steps for producing the capacitor. The invention thereby enables producing capacitors for integration in an SDL circuit, for example to be used for the power supply in the circuit, which exhibit superior electrical performance combined with advanced scalability to nanosized dimensions.

## Description

### Field of the Invention

The present invention is related to the fabrication of superconducting digital logic circuits.

### State of the art.

Superconducting digital logic (SDL) is one of the main technologies of interest for overcoming inherent limitations in terms of energy efficiency of CMOS based integrated circuits. An SDL circuit is configured to operate at temperatures near the absolute minimum and comprises electrical conductors formed of a material having superconducting properties at these low temperatures. Active devices include Josephson Junctions which enable changing the magnetic flux in a superconducting loop by an integer number of a single magnetic flux quantum (SFQ), while power delivery requires the integration of capacitors, comprising electrodes of superconducting material with a dielectric material sandwiched therebetween.

Although SDL circuits have existed for decades, there have been fundamental challenges to fabricate and scale down the circuit components and related interconnects for high density digital stacks.

An example of an SDL architecture is illustrated in patent publication document WO2023122069, with Josephson junctions and capacitors integrated in a stacked multilayer structure that is similar to the back-end-of-line stacks in standard CMOS technology. As stated, the scaling down of the various components in a multilayer structure of this type remains an ongoing challenge.

One particular bottleneck in this downscaling evolution is represented by the fabrication of the power distribution capacitors integrated in the multilayer structure. Using presently available material combinations and processing techniques, the in-plane dimensions of the capacitors cannot be reduced below about 2 micrometres without losing control of the capacitor's functional requirements. The aim of the present invention is to provide a solution to this particular problem.

### Summary of the invention

The invention is related to products and methods in accordance with the appended claims. The invention is related in particular to a micro-electronic component comprising superconducting digital logic circuitry, including at least one capacitor that comprises a bottom and top electrode formed of superconducting NbTiN, and a dielectric interlayer formed of orthorhombic HZO. A method for producing the capacitor includes method steps for producing of NbTiN electrodes defined by atomic concentrations of its constituent elements which enable superconductivity as well as the formation of HZO in the orthorhombic phase that remains stable throughout the sequence of method steps for producing the capacitor. The invention thereby enables producing capacitors for integration in an SDL circuit, for example to be used for the power supply in the circuit, which exhibit superior electrical performance combined with advanced scalability to nanosized dimensions.

Throughout the present description, the term 'superconducting NbTiN' is defined as NbTiN exhibiting superconducting properties below the critical temperature of the material NbTiN.

The width of a capacitor electrode is defined within the present context as the largest in-plane dimension of the capacitor electrode. This is for example the diameter for a circular shape, or the diagonal for a rectangular or square shape.

The invention is in particular related to a micro-electronic component comprising superconducting digital logic circuitry, said circuitry comprising one or more capacitors, each capacitor comprising a bottom electrode and a top electrode formed of superconducting material and separated from each other by a layer of dielectric material, characterized in that at least one of said capacitors comprises a bottom and top electrode formed of superconducting NbₓTi₁₋ₓN, hereafter abbreviated as superconducting NbTiN, and a dielectric interlayer formed of orthorhombic Hf_{0.5}Zr_{0.5}O₂, hereafter abbreviated as orthorhombic HZO.

According to an embodiment, x is between 76 at% and 88 at%.

According to an embodiment, the width of the top electrode of said at least one capacitor is between 150 and 240 nm.

According to an embodiment, the thickness of the electrodes of said at least one capacitor is between 40 nm and 100 nm.

According to an embodiment, the thickness of said HZO interlayer is between 4 nm and 12 nm.

The invention is also related to a method for producing the at least one capacitor included in a micro-electronic component according to any one of the preceding claims, the method comprising the steps of :
- providing or producing a substrate having a planarized receiving surface configured to receive thereon the bottom electrode of the capacitor,
- producing on said receiving surface a bottom layer of superconducting NbTiN,
- producing on said bottom layer a layer of orthorhombic HZO,
- producing on said layer of HZO a top layer of superconducting NbTiN,
- patterning the bottom and top NbTiN layers and the HZO layers so as to obtain the capacitor, i.e. said bottom and top electrodes (6',8') of the capacitor and said orthorhombic HZO interlayer between the bottom and top electrodes,
- producing a superconducting via connection (33) contacting the top electrode of the capacitor.

According to an embodiment, at least the bottom NbTiN layer is produced by physical vapour deposition, hereafter abbreviated as PVD, using a Nb target and a Ti target mounted together in a PVD process chamber suitable for pulsed DC magnetron PVD, wherein a sputtering gas and N₂ gas are supplied to the process chamber and wherein the following PVD parameters are applied:
- Power coupled to Nb target: 700 W- 1200 W,
- Power coupled to Ti target: 500 W - 700 W,
- N₂/sputtering gas flow ratio : 0.4 - 0.7,
- Temperature : 300 °C - 500°C.

According to an embodiment, the HZO layer is produced by atomic layer deposition, hereafter abbreviated as ALD, and wherein :
- the ALD process is performed using the precursors HfCₗ₄, ZrCl₄ and H₂O,
- the ALD process is followed by annealing at a temperature between 400°C and 600°C and during a time between 60s and 1 hour.

According to an embodiment, the patterning step includes :
- producing a hardmask on the top layer of superconducting NbTiN,
- etching the top layer relative to the hardmask, by a plasma etch process using an HBr/Cl₂ based etch chemistry without inert gases, to thereby form the top electrode of the capacitor,
- etching the HZO layer relative to the hardmask, by a plasma etch process using a BCl₃ based chemistry without inert gases, to thereby form the HZO interlayer of the capacitor,
- etching the bottom layer of superconducting NbTiN relative to the hardmask, by a plasma etch process using an HBr/Cl₂ based etch chemistry without inert gases, to thereby obtain the bottom electrode of the capacitor.

According to another embodiment, the patterning step includes :
- producing a hardmask on the top layer of superconducting NbTiN,
- etching the top layer relative to the hardmask, by a plasma etch process using an HBr/Cl₂ based etch chemistry without inert gases, to thereby form the top electrode of the capacitor,
- etching the HZO layer relative to the hardmask, by a plasma etch process using a BCl₃ based chemistry without inert gases, to thereby form the HZO interlayer of the capacitor,
- producing a second mask fully covering the stack comprising the HZO interlayer, the top electrode and the hardmask, wherein the second mask is larger than the hardmask, and etching the bottom layer of superconducting NbTiN relative to the second mask, to thereby obtain the bottom electrode of the capacitor.

According to an embodiment, the method further comprises the step of producing a dielectric encapsulation layer conformally on the stack formed of the bottom electrode, the HZO interlayer, the top electrode and the hardmask, wherein the following steps are performed after producing said encapsulation layer :
- depositing an electrically isolating material on the substrate, said material embedding said stack covered by the encapsulation layer,
- planarizing the upper surface of the isolating material to a common level with the upper surface of the encapsulation layer, wherein said planarization is done by chemical mechanical polishing, applying three CMP steps as follows :
   ∘ a bulk CMP step for removing a bulk portion of the isolating material,
   ∘ a selective CMP step, i.e. a step that stops on the surface of the encapsulation layer, wherein the CMP time of the selective step lies between 90s and 120s and wherein an average pressure is applied on the planarized surface between 1.8 and 2.2 PSI,
   ∘ a buffering CMP step, wherein the CMP time of the buffering step is between 55 s and 70 s and wherein an average pressure is applied on the planarized surface between 1.8 and 2.2 PSI.

According to an embodiment, the encapsulation layer is a layer formed of silicon nitride.

According to an embodiment, the hardmask comprises at least a first hardmask layer directly on the top electrode of the capacitor, and wherein producing said superconducting via connection includes the steps of :
- after the planarizing step, removing the encapsulation layer from the upper surface of the hardmask,
- depositing a further layer of an electrically isolating material,
- planarizing the upper surface of the isolating material to a common level with the upper surface of the first hardmask layer,
- by lithography and etching, producing a via opening through the first hardmask layer, thereby exposing the top electrode of the capacitor at the bottom of the via opening,
- filling the via opening with superconducting NbTiN to thereby obtain the via connection.

According to an embodiment, said first layer of the hardmask is a SiN layer.

### Brief description of the figures

Figure 1 is a 3D view of a small portion of a substrate comprising NbTiN conductors and via connections, serving as a starting point for a method according to an embodiment of the invention.
Figures 2 to 26 illustrate key steps of the method according to said embodiment.
Figures 27 and 28 illustrate an embodiment wherein the bottom electrode of the capacitor is larger than the top electrode.

### Detailed description of the invention

The invention concerns the realization of a nanosized capacitor integrated in a superconducting digital logic circuit of a micro-electronic component, for example a semiconductor chip comprising said SDL circuit. The capacitor is characterized by a specific material combination that provides multiple benefits in terms of the obtainable dimensions and characteristics of the capacitor, making the capacitor highly suitable for integration in the power distribution circuit of a stacked multilayer SDL architecture.

NbTiN is a material known to have superconducting properties for certain atomic concentrations of the constituent elements Nb and Ti, at temperatures below the critical temperature (which is about 17°K for NbTiN). These concentrations are expressed in the stoichiometric formula NbₓTi₁₋ₓN of the material, wherein x is the atomic percentage (in at%) of Nb. NbTiN exhibits good stability during the various processing steps required to produce a multilayer SDL circuit, which distinguishes this material from other superconducting materials like Nb and NbN. In particular, the surface of a NbTiN layer shows low reactivity with oxygen which is advantageous when an oxide is produced on the NbTiN.

HZO is a dielectric material defined by its formula Hf_{0.5}Zr_{0.5}O₂. The use of HZO as a dielectric layer sandwiched between the electrodes of a capacitor has been explored for TiN electrodes which are however not superconducting. NbTiN has been studied as a material for the superconducting electrodes of the Josephson junction as well as for the interconnecting conductors of superconducting circuitry. A capacitor comprising superconducting NbTiN electrodes combined with hafnium oxide as the dielectric is mentioned in document WO2023122069 cited in the introduction. Hafnium oxide however does not exhibit the desired crystallographic phase for optimal operational characteristics.

The present invention discloses a process sequence for producing a capacitor integrated in a multilayer SDL circuit, wherein the bottom and top electrodes of the capacitor are formed of superconducting NbTiN while the non-superconducting layer in between the electrodes is formed of HZO in the orthorhomibic phase. This crystal structure of the material is advantageous in its application in capacitors because of its inherent ferroelectric properties.

An example is described hereafter of a process sequence for producing a NbTiN/HZO/NbTiN capacitor integrated in the multilayer structure of an SDL circuit. The dimensions cited in the following description are mentioned by way of example only, and are not limiting the scope of the invention.

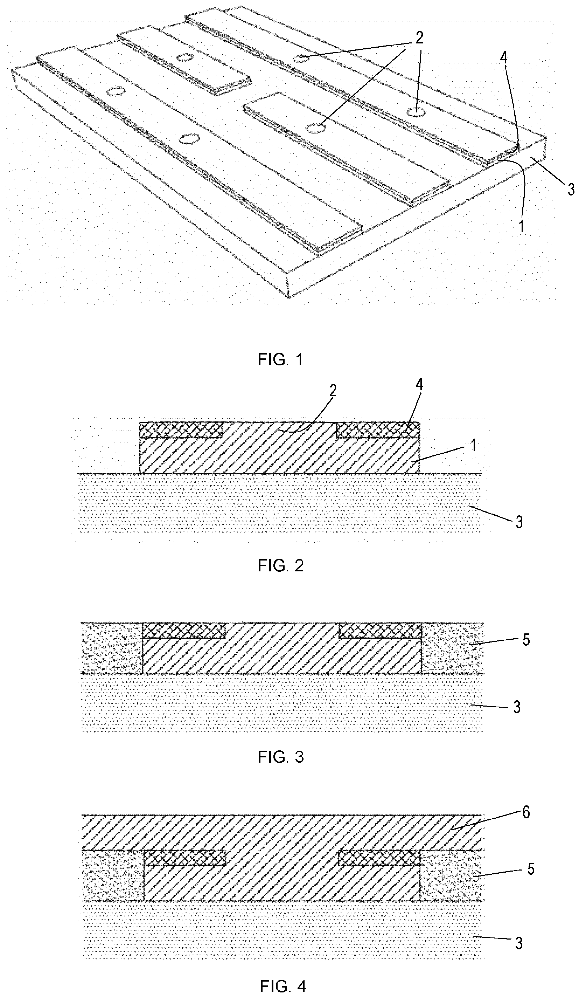

Figure 1 shows a small portion of one level of a multilayer SDL circuit, comprising a number of parallel line-shaped conductors 1 with interconnect vias 2 formed at specific locations on the upper surface of the conductors. The conductors and via connections are formed of superconducting NbTiN. The conductors 1 can be produced by methods known in the art for producing NbTiN conductors on a planarized receiving surface of a substrate, which include depositing a blanket NbTiN layer and patterning the layer by a number of lithography and etching steps.

The via connections 2 are embedded in layers 4 which are aligned to the conductors 1. Layers 4 are formed of a dielectric material that is part of a hardmask applied on the NbTiN blanket layer in the above-mentioned lithography and etching step. The layers 4 also perform the function of a CMP stopping layer in a CMP process step (Chemical Mechanical Polishing) for forming the via connections 2. This particular process for forming the via connections is not limiting the scope of the invention but it is a preferred process for producing a via connection that contacts a capacitor according to the invention. The process in question will be described further in this text in relation to the production of a via connection contacting the top electrode of the capacitor. The dielectric layers 4 may for example be formed of silicon nitride. The composition of the silicon nitride layers 4 is Si₃N₄ with possibly small deviations from the exact stoichiometric coefficients 3 and 4. Silicon nitride defined in this way will hereafter be referred to as 'SiN'.

The conductors 1 are formed on the planarized receiving surface of a substrate 3. If the conductors 1 are part of the first level of the multilayer structure, the substrate 3 can be a silicon process wafer for example. In that case, the conductors are part of the M₁ level of the multilayer structure. The conductors 1 can also be part of a higher level Mₓ of the structure, in which case the receiving surface of the substrate 3 is the planarized surface of the Mₓ₋₁ level.

A cross-section through the centre of one of the via connections 2 is shown in Figure 2. The subsequent drawings illustrate a process sequence performed on the substrate for producing a capacitor in contact with the via connection 2, in accordance with the invention. The formation of a via connection connecting the capacitor to the next level of the multilayer structure will also be described.

According to the non-limiting embodiment illustrated in the drawings and further described hereafter, the width of the conductors 1 is about 300 nm and the diameter of the via connections 2 is about 130 nm while the thickness of the conductors 1 is about 50 nm and the thickness of the via connections 2 and of the SiN layers 4 is about 20 nm. As stated however, the invention is not limited to these particular dimensions.

As seen in Figure 3, a dielectric layer 5 is produced on the full surface of the substrate, and planarized to the level of the upper surface of the via connections 2. The planarization is done by standard techniques, including CMP. The SiN layers 4 act as CMP stopping layers in the planarization process. The dielectric material of layer 5 may be a silicon oxide layer or a low-K dielectric layer, or any other layer suitable as an interlayer dielectric material (ILD) in a back end of line interconnect structure as known from standard Si-based CMOS process flows. Silicon oxide's compositional formula is SiO₂, with possible small deviations from the pure stoichiometric composition defined by the formula. Silicon oxide defined in this way will hereafter be referred to as 'SiOx'.

With reference to Figure 3, a layer 6 of NbTiN is produced on the planarized surface. The layer has a thickness of about 50 nm. A preferred method for obtaining the layer 6 in accordance with the invention comprises method steps as described hereafter.

The planarized substrate is placed in a process chamber of a PVD (Physical Vapour Deposition) pulsed DC magnetron PVD installation for sputtering PVD. A Nb target and a Ti target are mounted in the process chamber and coupled to respective power sources for creating a voltage difference between the substrate 3 and the targets. With the process chamber under vacuum conditions, a sputtering gas is introduced in the chamber enabling the formation of a plasma discharge in the vicinity of the targets under the influence of the voltage differences. Argon is preferably used as the sputtering gas. Nitrogen gas (N₂) is supplied together with the Ar. The preferred method applies PVD parameters within the following ranges :
Power coupled to Nb target: 700 W- 1200 W
Power coupled to Ti target: 500 W- 700 W
N₂/Ar flow ratio : 0.4 - 0.7
Temperature : 300°C - 500°C

The duration of the deposition process determines the thickness of the NbTiN layer. The vacuum level is preferably about 0.0013Torr. Small variations from this value may be applied depending on the the required value of x in the obtained NbₓTi₁₋ₓN variant. PVD parameters not defined above can be in accordance with known practice for depositing NbTiN and can be applied as such by persons skilled in the art.

Under these conditions, superconducting NbTiN is deposited, i.e. NbₓTi₁₋ₓN, wherein x is configured so that the material exhibits superconducting properties at temperatures below the critical temperature (which is about 17°K for NbTiN). In addition, the NbTiN deposited under these conditions enables the formation of orthorhombic HZO on the NbTiN layer. A preferred range for the atomic percentage x for obtaining the combined enablement of these features, namely superconducting properties and formation of orthorhombic HZO, is the range between 76at% and 88at%. The formation of a NbₓTi₁₋ₓN layer with x between 76at% and 88at% is obtainable by applying the above-described PVD parameters.

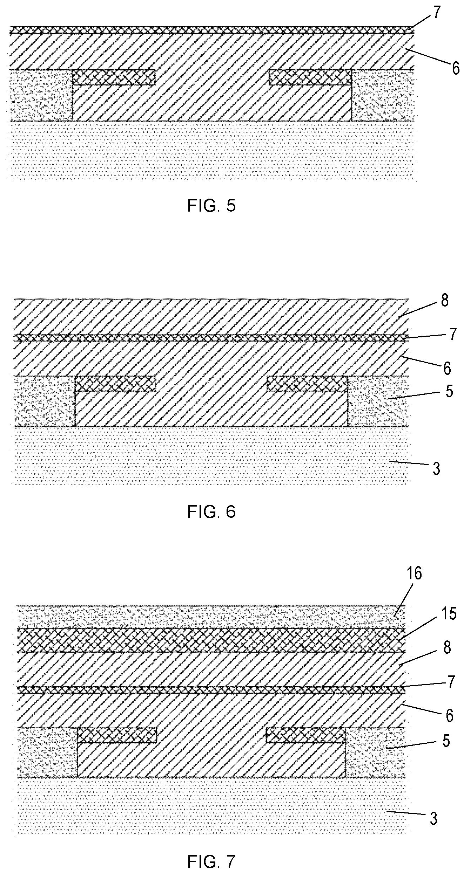

With reference to Figure 5, a layer 7 of orthorhombic HZO of about 9 nm thick is then formed on the NbTiN layer 5. A preferred method for obtaining HZO in the orthorhombic phase on the NbTiN layer 6 obtained as described above, is atomic layer deposition (ALD). The substrate is placed in the reactor chamber of an ALD installation and the deposition process is preferably performed at a temperature of 300°C at 2Torr reactor pressure, using as the precursors: HfCl₄, ZrCl₄ as metal sources and H₂O as oxidant. At this stage the HZO is only partially crystallized. Subsequently, the substrate is preferably annealed at a temperature between 400°C and 600°C, in a rapid thermal annealing oven using N2 as carrier gas at ambient pressure for 1 hr at 400°C, while duration can be reduced to 1 min if annealing is performed at 600°C. The complete crystallization of the HZO film occurs as result of the annealing step with predominantly formed polar orthorhombic phase.

ALD parameters not defined above can be in accordance with known practice for depositing NbTiN and can be applied as such by persons skilled in the art. Applying these parameters enables obtaining HZO in the orthorhombic phase, having optimal ferroelectric characteristics.

As shown in Figure 6, a second superconducting NbTiN layer 8 of about 50 nm thick is then formed by PVD on the HZO layer 7. The same parameters may be used as described above for the deposition of the first NbTiN layer 6.

This is followed by patterning the NbTiN layers 6 and 8 and the HZO layer 7, in order to form the bottom and top electrodes of the capacitor, with an HZO interlayer sandwiched between the electrodes.

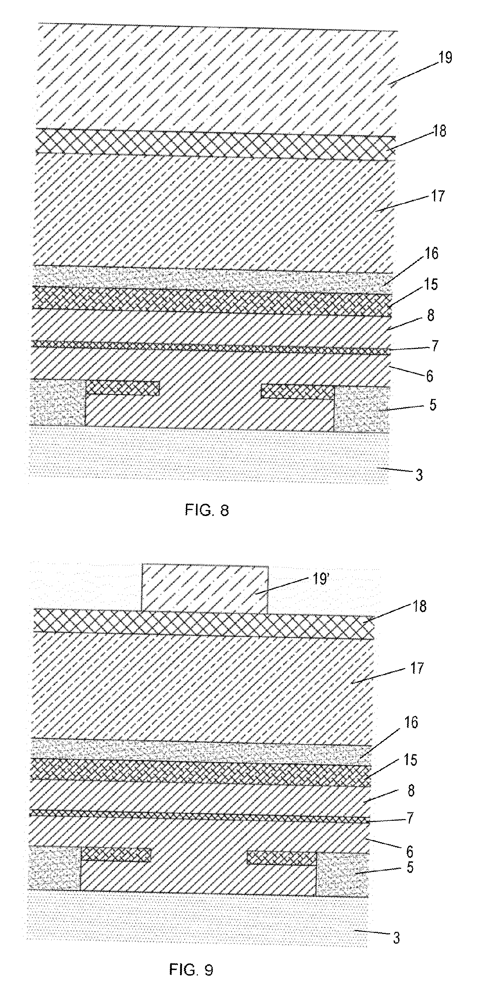

With reference to Figure 7, a silicon nitride layer 15 of about 30 nm thick is produced directly on the top NbTiN layer 8, followed by a SiOx layer 16 of about the same thickness as the SiN layer 15. Layers 15 and 16 can be produced by methods known as such in the art, for example: layer 15 can be produced by Plasma Enhanced ALD and layer 16 can be produced by ALD.With reference to Figure 8, a lithographic stack 17,18,19 is formed on the SiOx layer 16, the stack comprising: an amorphous carbon layer 17, an SiOC (silicon oxycarbide) layer 18 and a resist layer 19. This is a well-known type of litho stack, and thicknesses of its constituting layers as well as the method for applying the layers may be in accordance with known practice. The material of these layers can be different from the above-cited materials.

The resist layer 19 is patterned by exposure to light through a patterned mask and after development and stripping of the non-patterned resist, a resist mask 19' remains, as illustrated in Figure 9. The mask has a circular cross-section with a diameter of about 190 nm. The shape of the cross-section may be other than circular however, for example rectangular or square.

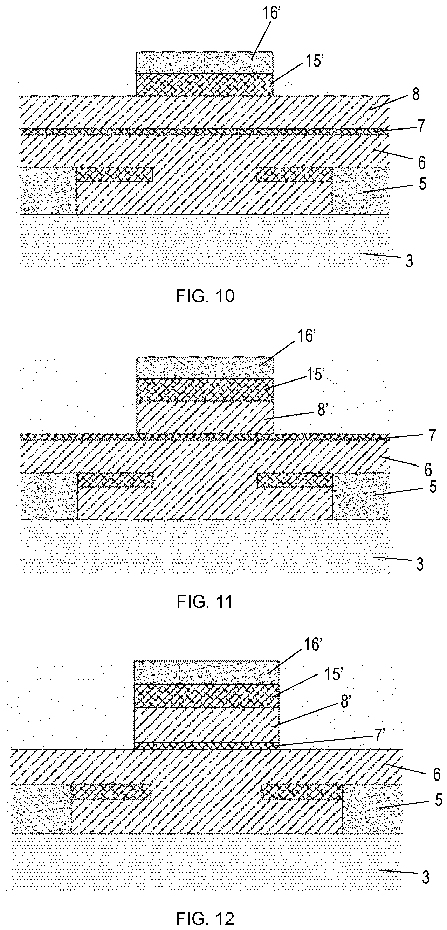

With reference to Figure 10, the resist mask 19' is then transferred by etching, to the underlying layers, the SiOC layer 18, the amorphous carbon layer 17, the SiOx layer 16, and the SiN layer 15, after which the remainder of the lithostack is stripped. The stack of layers 15 and 16 now becomes a patterned hardmask 15'/16' having the same diameter as the resist mask 19'.

By a plasma etch process illustrated in Figure 11, the hardmask 15'/16' is transferred to the underlying NbTiN layer 8 to produce the top electrode 8' of the capacitor. The NbTiN layer 8 is preferably etched by plasma etching using an HBr/Cl₂ etch chemistry without inert gases, and using standard etch parameters in terms of the mixing ratio, applied power and gas pressures. The applied chemistry is selective with respect to HZO, so that the HZO layer 7 acts as an etch stop layer. However, it is preferred to limit the etch time in order to avoid underetching of the NbTiN top electrode 8'. For etching a NbTiN thickness of 50 nm, an etch time is required between 80s and 100s. For thicker NbTiN layers, the etch time can be longer.

With reference to Figure 12, a different plasma chemistry, namely BCl₃ without inert gases, is used for etching the HZO layer 7, in order to produce the capacitor's interlayer 7', applying standard etch parameters in terms of the mixing ratio, applied power and gas pressures. For an HZO layer thickness of about 9nm, the etch time is preferably between 30 s and 40 s. Generally, for HZO layer thicknesses between 4 nm and 12 nm, the etch time is preferably between 20 s and 45 s.

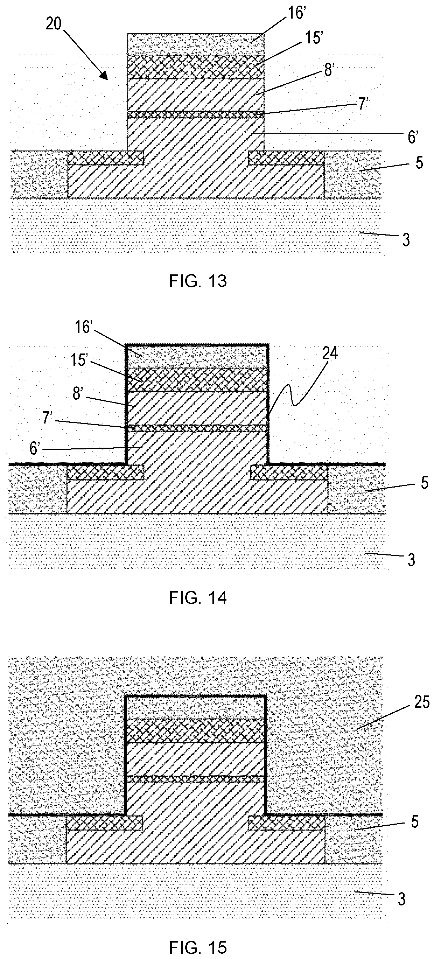

Thereafter, the bottom NbTiN layer 6 is etched, as illustrated in Figure 13, for producing the bottom electrode 6' of the capacitor. The etch recipe used for the top layer 8 can be used also for the bottom layer 6. The result is a stack 20 comprising the capacitor 6'+7'+8' and the hardmask layers 15' and 16'.

With reference to Figure 14, a layer 24 of SiN (as defined above) is deposited conformally on the stack 20. A conformal deposition is a deposition that follows the topography of the surface onto which the layer is deposited : the SiN layer 24 has a thickness that enables such a conformal deposition. In the illustrated embodiment, said thickness of the conformal SiN layer 24 may be in the order of 10 nm. This may be realized by plasma enhanced physical vapour deposition (PECVD) applied in-situ, i.e. in the same chamber as the plasma etch process used for patterning the layers 6,7 and 8. The conformal SiN layer 24 is one example of a protective dielectric encapsulation layer that protects the sidewalls of the electrodes 6', 8' and the HZO interlayer 7' during subsequent processing steps. The thickness of the conformal layer 24 may generally be between 5 nm and 15 nm. Other techniques besides PECVD can be applied.

The in-situ deposition referred to above is advantageous because it ensures that no native oxide growth occurs on the stack 20 prior to the deposition of the conformal layer 24. Nevertheless, it is also possible to deposit the conformal layer 'ex-situ', i.e. after exposing the stack 20 to an oxygen-containing atmosphere. In that case however, the deposition of the conformal layer 24 must be preceded by a precleaning step using a wet cleaning chemistry for removing the native oxide, or by an ion milling step.

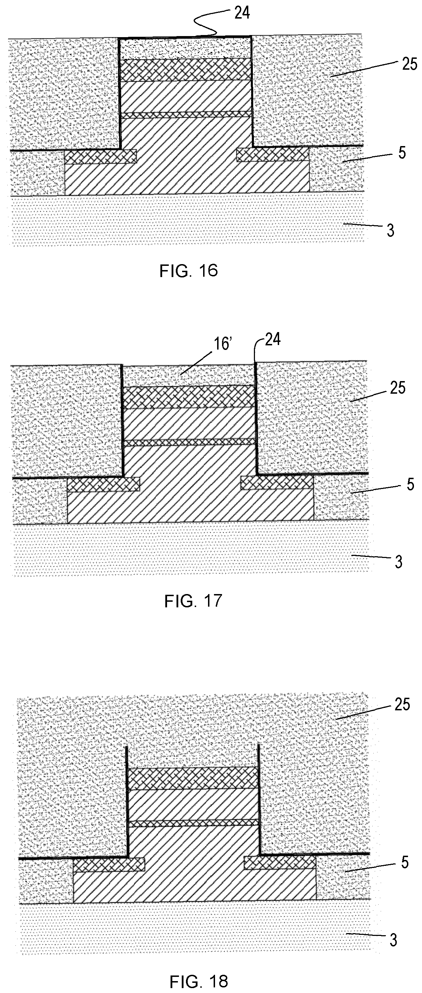

With reference to Figure 15, the stack 20 is embedded in a dielectric layer 25, which may be a silicon oxide layer or a low-K dielectric layer, or any other layer suitable as an interlayer dielectric material (ILD) in a back end of line interconnect structure as known from standard Si-based CMOS process flows. Thereafter, as shown in Figure 16, the ILD layer 25 is planarized to the level of the upper surface of the SiN encapsulation layer 24. The planarization is done by CMP. According to a preferred embodiment, a CMP recipe is applied that has no or little impact on the phase of the HZO, i.e. that essentially preserves the orthorhombic phase. There are 3 sub-steps in said preferred CMP process :
- a bulk CMP step for removing a bulk portion of the ILD material 25. This step is stopped before reaching the SiN layer 24. This step is performed using a standard average pressure on the surface that is being planarized, for example 2.2 PSI and during a time that depends on the thickness of the ILD layer 25, for example about 50 s..
- a selective CMP step, i.e. a step that stops on the SiN surface of the layer 24. The CMP time of this step preferably lies between 90s and 120s. Average pressure may be between 1.8 and 2.2 PSI.
- a buffering CMP step: time between 55 and 70 s. Average pressure may be between 1.8 and 2.2 PSI.

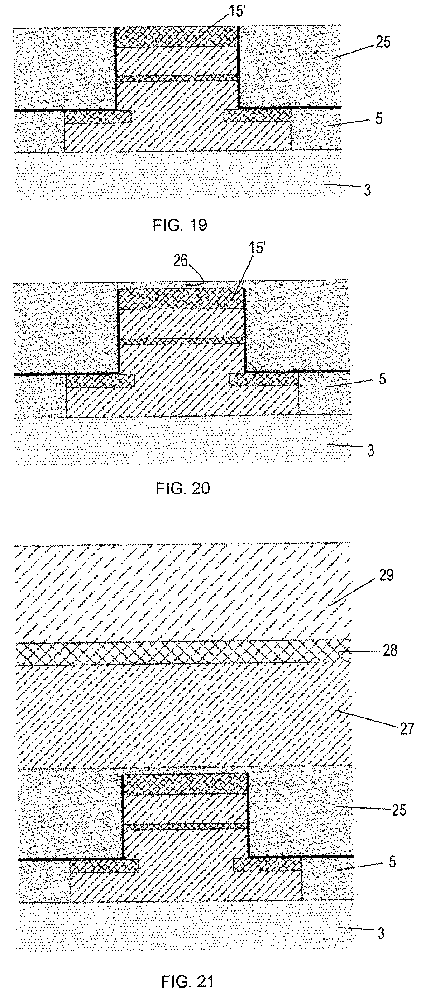

CMP parameters not explicitly described above can be according to known practice. Commercially available CMP slurries can be used for obtaining the correct selectivity, i.e. stopping on the SiN layer 24. After the above-described planarization by CMP, the SiN of layer 24 is then etched back relative to the ILD material 25, as shown in Figure 17, and the obtained recess is filled with further ILD material 25 as illustrated in Figure 18, followed, as shown in Figure 19, by another planarization step, stopping on the upper surface of the SiN hardmask portion 15' originating from layer 15. The latter planarization step is preferably applied using the same CMP sequence as described above in reference to Figure 16.

A thin further ILD layer 26 of about 10 nm thick is then preferably deposited, as seen in Figure 20. This layer is formed to protect the SiN hardmask portion 15' from resist poisoning. This step is followed by the formation of another lithographic stack 27-29 (see Fig. 21) which can for example be a stack of a spin-on-carbon layer (SoC layer 27) and a spin-on-glass layer (SoG layer 28) capped with a resist layer 29. The SoCl/SoG stack is well known to the skilled person. In the non-limiting embodiment described here, the SoC layer has a thickness of about 100 nm, the SoG layer has a thickness of about 28 nm and the resist may have a thickness of about 200 nm.

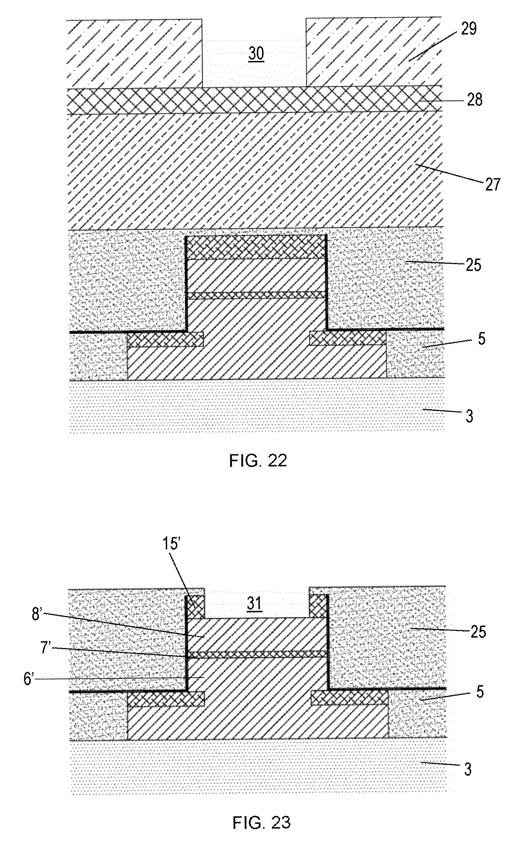

The resist 29 is patterned as shown in Figure 22, i.e. a cylindrical opening 30 is formed having a diameter of about 130nm and located essentially concentrically with respect to the capacitor. However, a certain misalignment is allowable as long as the opening 30 lies within the surface area of the top electrode 8' of the capacitor. The resist pattern is transferred by a suitable etch recipe to the layers 28 and 27 of the lithostack and further to the ILD layer 26 and the SiN layer 15', stopping on the NbTiN top electrode 8' of the capacitor. After stripping of the remaining litho-stack layers, this results in the situation illustrated in Figure 23. A via opening 31 is formed above the top electrode 8' of the capacitor, exposing said top electrode at the bottom of the via opening 31.

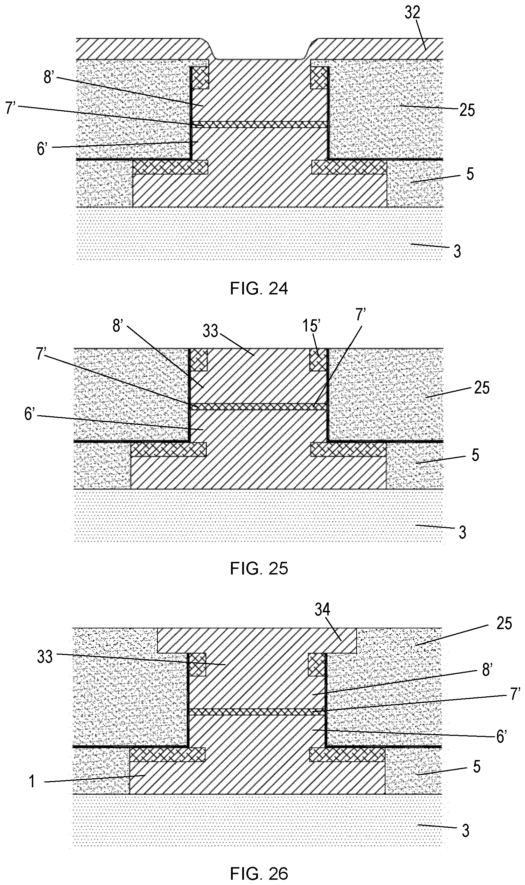

With reference to Figure 24, the via opening 31 is filled with superconducting NbTiN that is deposited in said opening 31 and on top of the planarized surface, forming a layer 32. Preferably a pre-cleaning step is performed using argon, prior to NbTiN deposition, in order to remove surface oxides. Layer 32 is produced according to a known method, which may be PVD, but not necessarily applying the same parameters defined above for producing layers 6 and 8. As illustrated in Figure 25, the NbTiN layer 32 is then thinned and planarized to a common level with the ILD material 25, to thereby form a superconducting NbTiN via connection 33 (the filled via opening 31). The planarization may apply a similar CMP sequence as described above with reference to Figure 16. However, different commercially available CMP slurries are preferably used compared to the planarization shown in Figure 16. In the planarization illustrated in Figure 25, CMP slurries are used which are suitable for obtaining the correct selectivity for planarizing NbTiN of the via 33 and stopping on the SiN surface of layer 15'.

Thereafter, as illustrated in Figure 26, a superconducting NbTiN conductor 34 is formed, belonging to the metallization level Mx+1, and embedded in ILD material 25. Producing the conductor 34 can be done according to a known method, for example applying PVD for producing a blanket NbTiN layer, and patterning the layer in a similar way as described above in relation to the formation of the capacitor's electrodes 6' and 8'. Prior to depositing the blanket NbTiN layer, preferably a pre-cleaning step is performed using argon, in order to remove surface oxides.

The method steps described thereby produce the capacitor 6'+7'+8', connected to a first conductor 1 in level Mₓ and to a second conductor 34 in level Mₓ₊₁ of a stacked multilevel SDL configuration.

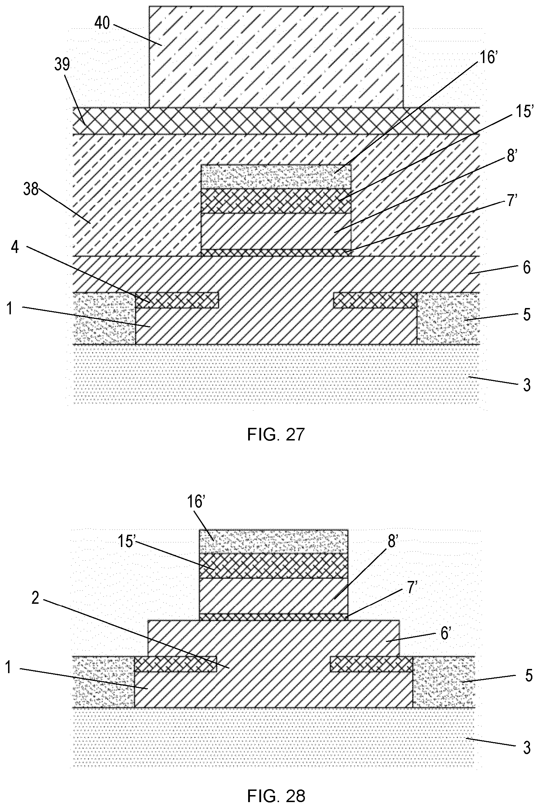

The invention is not limited to capacitors wherein the bottom and top electrodes have the same in-plane dimensions. In other embodiments, the bottom electrode may be larger than the top electrode for example. This can be achieved by the method steps as described above, except that the hardmask 15'/16' is used only for etching the top NbTiN layer 8 and the HZO layer 7. Thereafter, a second lithographic mask is used for etching the bottom electrode. This is illustrated in Figure 27. The second mask is the patterned resist layer 40 of a lithographic stack 38,39,40. With reference to Figure 28, the dimensions of the second mask 40 are transferred by etching to the bottom NbTiN layer 6, to obtain the bottom electrode 6' having a larger diameter than the top electrode 8' and the HZO interlayer 7'. After this stage, the same steps as described above can be applied, starting with the formation of a conformal dielectric (e.g. SiN) encapsulation layer that follows the topography of the capacitor 6'+7'+8'. In an alternative embodiment, a first conformal dielectric encapsulation layer is applied prior to the formation of the second mask 40, i.e. on the topography shown in Figure 12. Then the bottom electrode 6' is etched, and a second encapsulation layer is formed, so that on the stack of layers 7',8',15' and 16', the final encapsulation layer is twice as thick as on the on bottom electrode 6'. This double layer is then removed from the upper surface of layer 16', and the remaining method steps are performed as described above.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A micro-electronic component comprising superconducting digital logic circuitry, said circuitry comprising one or more capacitors, each capacitor comprising a bottom electrode and a top electrode formed of superconducting material and separated from each other by a layer of dielectric material, **characterized in that** at least one of said capacitors comprises a bottom and top electrode (6',8') formed of superconducting NbₓTi₁₋ₓN, hereafter abbreviated as superconducting NbTiN, and a dielectric interlayer (7') formed of orthorhombic Hf_{0.5}Zr_{0.5}O₂, hereafter abbreviated as orthorhombic HZO.

2. The component according to claim 1, wherein x is between 76 at% and 88 at%.

3. The component according to claim 1 or 2, wherein the width of the top electrode of said at least one capacitor is between 150 and 240 nm.

4. The component according to any one of the preceding claims, wherein the thickness of the electrodes of said at least one capacitor is between 40 nm and 100 nm.

5. The component according to any one of the preceding claims, wherein the thickness of said HZO interlayer (7') is between 4 nm and 12 nm.

6. A method for producing the at least one capacitor included in a micro-electronic component according to any one of the preceding claims, the method comprising the steps of :
- providing or producing a substrate (3) having a planarized receiving surface configured to receive thereon the bottom electrode of the capacitor,
- producing on said receiving surface a bottom layer (6) of superconducting NbTiN,
- producing on said bottom layer a layer (7) of orthorhombic HZO,
- producing on said layer of HZO a top layer (8) of superconducting NbTiN,
- patterning the bottom and top NbTiN layers and the HZO layers so as to obtain the capacitor, i.e. said bottom and top electrodes (6',8') of the capacitor and said orthorhombic HZO interlayer (7') between the bottom and top electrodes,
- producing a superconducting via connection (33) contacting the top electrode (8') of the capacitor.

7. The method according to claim 6, wherein at least the bottom NbTiN layer (6) is produced by physical vapour deposition, hereafter abbreviated as PVD, using a Nb target and a Ti target mounted together in a PVD process chamber suitable for pulsed DC magnetron PVD, wherein a sputtering gas and N₂ gas are supplied to the process chamber and wherein the following PVD parameters are applied:
- Power coupled to Nb target: 700 W- 1200 W,
- Power coupled to Ti target: 500 W - 700 W,
- N₂/sputtering gas flow ratio : 0.4 - 0.7,
- Temperature : 300 °C - 500°C.

8. The method according to claim 7 or 8 , wherein the HZO layer (7) is produced by atomic layer deposition, hereafter abbreviated as ALD, and wherein :
- the ALD process is performed using the precursors HfCₗ₄, ZrCl₄ and H₂O,
- the ALD process is followed by annealing at a temperature between 400°C and 600°C and during a time between 60s and 1 hour.

9. The method according to any one of claims 6 to 8, wherein the patterning step includes :
- producing a hardmask (15', 16') on the top layer (8) of superconducting NbTiN,
- etching the top layer (8) relative to the hardmask, by a plasma etch process using an HBr/Cl₂ based etch chemistry without inert gases, to thereby form the top electrode (8') of the capacitor,
- etching the HZO layer (7) relative to the hardmask, by a plasma etch process using a BCl₃ based chemistry without inert gases, to thereby form the HZO interlayer (7') of the capacitor,
- etching the bottom layer of superconducting NbTiN relative to the hardmask, by a plasma etch process using an HBr/Cl₂ based etch chemistry without inert gases, to thereby obtain the bottom electrode (6') of the capacitor.

10. The method according to any one of claims 6 to 8, wherein the patterning step includes :
- producing a hardmask (15', 16') on the top layer (8) of superconducting NbTiN,
- etching the top layer (8) relative to the hardmask, by a plasma etch process using an HBr/Cl₂ based etch chemistry without inert gases, to thereby form the top electrode (8') of the capacitor,
- etching the HZO layer (7) relative to the hardmask, by a plasma etch process using a BCl₃ based chemistry without inert gases, to thereby form the HZO interlayer (7') of the capacitor,
- producing a second mask (40) fully covering the stack comprising the HZO interlayer (7'), the top electrode (8') and the hardmask (15'/16'), wherein the second mask is larger than the hardmask, and etching the bottom layer of superconducting NbTiN (6) relative to the second mask, to thereby obtain the bottom electrode (6') of the capacitor.

11. The method according to claim 9 or 10, further comprising the step of producing a dielectric encapsulation layer (24) conformally on the stack (20) formed of the bottom electrode (6'), the HZO interlayer (7'), the top electrode (8') and the hardmask (15'/16'), and wherein the following steps are performed after producing said encapsulation layer (24) :
- depositing an electrically isolating material (25) on the substrate, said material embedding said stack (20) covered by the encapsulation layer (24),
- planarizing the upper surface of the isolating material (25) to a common level with the upper surface of the encapsulation layer (24), wherein said planarization is done by chemical mechanical polishing, applying three CMP steps as follows :
∘ a bulk CMP step for removing a bulk portion of the isolating material,
∘ a selective CMP step, i.e. a step that stops on the surface of the encapsulation layer (24), wherein the CMP time of the selective step lies between 90s and 120s and wherein an average pressure is applied on the planarized surface between 1.8 and 2.2 PSI,
∘ a buffering CMP step, wherein the CMP time of the buffering step is between 55 s and 70 s and wherein an average pressure is applied on the planarized surface between 1.8 and 2.2 PSI.

12. The method according to claim 11, wherein the encapsulation layer (24) is a layer formed of silicon nitride.

13. The method according to claim 11 or 12, wherein the hardmask (15', 16') comprises at least a first hardmask layer (15') directly on the top electrode (8') of the capacitor, and wherein producing said superconducting via connection (33) includes the steps of :
- after the planarizing step, removing the encapsulation layer (24) from the upper surface of the hardmask (15', 16'),
- depositing a further layer of an electrically isolating material (25),
- planarizing the upper surface of the isolating material (25) to a common level with the upper surface of the first hardmask layer (15'),
- by lithography and etching, producing a via opening (31) through the first hardmask layer (15'), thereby exposing the top electrode (8') of the capacitor at the bottom of the via opening (31),
- filling the via opening (31) with superconducting NbTiN to thereby obtain the via connection (33).

14. The method according to claim 13, wherein said first layer (15') of the hardmask is a SiN layer.
